# EUROPÄISCHE PATENTANMELDUNG

(11) **EP 0 759 449 A2**
(43) Veröffentlichungstag der Anmeldung: **26.02.1997**
(21) Anmeldenummer: 96113059.8
(22) Anmeldetag: 14.08.1996
(51) Int. Cl.: C08G 8/12, C08G 8/00, C08L 61/04, C09D 161/04, G03F 7/004

(54) **Verfahren zur Herstellung von methylsubstituierten Polyalkylidenpolyphenolen**

(30) Priorität: 21.08.1995 DE 19530630
(71) Anmelder: Vianova Resins GmbH, 55252 Mainz-Kastel (DE)
(72) Erfinder: Burkhart, Thomas, Dr., 65396 Walluf (DE); Hesse, Wolfgang, Dr., 26655 Westerstede (DE); Leicht, Erhard, Dr., 65719 Hofheim (DE)

(57) **Zusammenfassung**

Verfahren zur Herstellung von methylsubstituierten Polyalkylidenpolyphenolen, die in Mischungen mit Kautschuk oder als Bindemittel in lichtempfindlichen Massen eingesetzt werden können und erhalten werden, indem gegenüber Oxoverbindungen bifunktionelle und/oder trifunktionelle methylsubstituierte Phenole mit Oxoverbindungen in Gegenwart saurer Katalysatoren in erster Stufe zu einem niedermolekularen Polyalkylidenpolyphenol reagiert werden, wobei das Einsatzmolverhältnis zwischen phenolischer Komponente und Oxoverbindungen zwischen 1 : 0,2 bis 1 : 0,7 liegt, die nicht umgesetzten phenolischen Komponenten anschließend destillativ entfernt werden und in zweiter Stufe das nach der Destillation zurückgebliebene niedermolekulare Polyalkylidenpolyphenol in Gegenwart von sauren oder basischen Katalysatoren mit weiteren Oxoverbindungen umgesetzt wird.

## Beschreibung

Die vorliegende Erfindung betrifft ein zweistufiges Verfahren zur Herstellung von Polyalkylidenpolyphenolen mit enger Molekularmassenverteilung ausgehend von methylsubstituierten Phenolen sowie deren Verwendung in Mischungen mit Kautschuk oder als Bindemittel in lichtempfindlichen Massen.

Es ist bekannt, aus methylsubstituierten Phenolen durch Kondensation mit Oxoverbindungen Polyalkylidenpolyphenole herzustellen (Ullmann's Encyclopedia of Industrial Chemistry, Paints und Coatings, Vol. A 18 (1991), 420 sowie EP-A 0 429 667). Dazu werden methylsubstituierte Phenole, also Kresole beziehungsweise Xylenole, üblicherweise als Isomerengemisch, mit Oxoverbindungen, zumeist Formaldehyd, in Gegenwart von sauren Katalysatoren erhitzt. Anschließend können die nicht umgesetzten methylsubstituierten Phenole destillativ und/oder extraktiv entfernt werden. Dabei kann ein Teil der niedermolekularen Kondensationsprodukte ebenfalls abgetrennt werden.

Nach den bekannten Verfahren können Harze erhalten werden, deren Erweichungspunkt, den anwendungstechnischen Erfordernissen entsprechend, vorzugsweise zwischen 100 und 120 °C liegt, deren Molekularmasse jedoch in sehr hohe Bereiche geht und eine sehr breite Molekularmassenverteilung aufweist. Die Anteile mit hoher Molekularmasse stören die Verträglichkeit mit Kombinationspartnern, beispielsweise mit Kautschuken, und verschlechtern die Verträglichkeit mit Lösemitteln und Reaktionspartnern. Sie stören auch das Adhäsionsverhalten auf Substraten, wenn Beschichtungen wieder abgelöst werden sollen. Durch die starke Adhäsion der hochmolekularen Anteile lösen diese sich nicht oder nur schwer vom Substrat ab.

Die Aufgabe der vorliegenden Erfindung bestand darin, ein Verfahren zur Herstellung von methylsubstituierten Polyalkylidenpolyphenolen zur Verfügung zu stellen, das Produkte mit nur geringen Mengen an niedermolekularen Kondensationsprodukten, enger Molekularmassenverteilung, hohen Erweichungstemperaturen und verbesserten Löslichkeits- und Verträglichkeitseigenschaften liefert.

Gelöst wird diese Aufgabe durch ein zweistufiges Herstellverfahren, bei dem zwischen den beiden Reaktionsstufen niedermolekulare Anteile destillativ entfernt werden.

Gegenstand der Erfindung ist ein Verfahren zur Herstellung von methylsubstituierten Polyalkylidenpolyphenolen, dadurch gekennzeichnet, daß gegenüber Oxoverbindungen bifunktionelle und/oder trifunktionelle alkylsubstituierte Phenole mit Oxoverbindungen in Gegenwart saurer Katalysatoren in erster Stufe zu einem niedermolekularen Polyalkylidenpolyphenol reagiert werden, wobei das Molverhältnis zwischen phenolischer Komponente und Oxoverbindungen zwischen 1 : 0,2 und 1 : 0,7 vorzugsweise bei 1 : 0,35 bis 1 : 0,6 liegt, die nicht umgesetzten phenolischen Komponenten anschließend destillativ entfernt werden und in zweiter Stufe das nach der Destillation zurückgebliebene niedermolekulare Polyalkylidenpolyphenol in Gegenwart von sauren oder basischen Katalysatoren mit weiteren Oxoverbindungen umgesetzt wird.

Als saure Katalysatoren werden bevorzugt starke Mineralsäuren und/oder ihre sauren Derivate, insbesondere Schwefelsäure, Hydrogensulfate oder Halbester der Schwefelsäure, oder organische Säuren, insbesondere Oxalsäure-Dihydrat und p-Toluolsulfonsäure, verwendet. Als basische Katalysatoren werden vorzugsweise Alkalihydroxide, insbesondere Natronlauge, Erdalkalihydroxide, Ammoniak oder Amine verwendet.

Das erfindungsgemäße Verfahren wird hinsichtlich der Umsetzung in der ersten und zweiten Stufe unter den für die Herstellung von Phenolharzen üblichen Reaktionsbedingungen durchgeführt. Die Reaktionen in der ersten und zweiten Stufe können beispielsweise unter Rückfluß bei einer Temperatur < 100 °C stattfinden. Vorzugsweise wird jedoch bei einer Temperatur > 110 °C in Gegenwart von nicht wassermischbaren und/oder nur teilweise wassermischbaren inerten organischen Lösungsmitteln insbesondere unter azeotroper Entfernung des Reaktionswassers gearbeitet.

Die Reaktionsprodukte werden nach der Umsetzung zu einer Lösung oder zu einem Festharz aufgearbeitet. Es ist zweckmäßig, die Katalysatoren nach dem jeweiligen Verfahrensschritt zu neutralisieren und gegebenenfalls abzutrennen. Bei Verwendung von sauren Katalysatoren kann dies durch Zugabe von mindestens äquivalenten Mengen an Basen, beispielsweise Aminen oder Metallhydroxiden geschehen; bei basischen Katalysatoren werden mindestens äquivalente Mengen an Säuren hinzugegeben.

Als methylsubstituierte Phenole können die drei Kresolisomeren oder die vier Xylenolisomeren oder Mischungen aus Kresolen und Xylenolen verwendet werden. Bevorzugt ist die Verwendung von Mischungen aus para- und ortho-Kresol, wobei das para- zu ortho-Verhältnis vorzugsweise 50 : 50 bis 95 : 5 beträgt.

Als Oxoverbindungen kommen vorzugsweise geradkettige oder verzweigte Aldehyde mit bis zu 12 Kohlenstoffatomen, beispielsweise Acetaldehyd, Propionaldehyd, n-Butyraldehyd oder Isobutyraldehyd und insbesondere Formaldehyd zur Anwendung.

Gegenstand der Erfindung sind auch die nach dem beanspruchten Verfahren erhältlichen methylsubstituierten Polyalkylidenpolyphenole mit einer Dispersität der Molekularmassenverteilung (Gewichtsmittel (M_{w})/Zahlenmittel (Mₙ)) < 4, vorzugsweise < 3,5, einer Glasübergangstemperatur oberhalb von 100 °C, vorzugsweise oberhalb von 110 °C, und einem Erweichungspunkt oberhalb von 120 °C, vorzugsweise oberhalb von 140 °C.

Die erfindungsgemäß hergestellten Polyalkylidenpolyphenole zeichnen sich dadurch aus, daß niedermolekulare Anteile wie Zweikern- und Dreikernverbindungen sowie Ausgangsphenole praktisch abwesend sind. Der Anteil der Zweikernverbindungen beträgt vorzugsweise < 0,1 Gew.-%, insbesondere < 0,05 Gew.-%, der Anteil der Dreikernverbindungen beträgt vorzugsweise < 1 Gew.-% insbesondere < 0,5 Gew.-%.

Gegenstand der Erfindung ist auch die Verwendung der methylsubstituierten Polyalkylidenpolyphenole als Verstärkerharz für Kautschukmischungen und als Klebrigmacher in synthetischen und natürlichen Kautschuken.

Für die Verwendung als Verstärkerharz werden die erfindungsgemäßen Harze mit Hexamethylentetramin und/oder Melaminharzen vernetzt. Für die übrigen Anwendungszwecke, insbesondere als Klebrigmacher für Urethan- und Nitrilkautschukklebstoffe werden keine Härter benötigt. Vorzugsweise werden den Kautschuken jedoch mit 1,3-Dioxoverbindungen komplexierte Alkoholate oder Phenolate von Aluminium, Zirkonium oder Titan zugesetzt.

Die erfindungsgemäßen methylsubstituierten Polyalkylidenpolyphenole ermöglichen ferner als Bindemittel in Diazoverbindungen enthaltenden lichtempfindlichen Massen die Herstellung von Systemen mit hoher thermischer Beständigkeit.

### Beispiele

Die in den Beispielen angegebenen Teile und Prozente beziehen sich auf das Gewicht, soweit nicht anders vermerkt.

Die Messung der Molekularmassenverteilung erfolgt gelchromatografisch. Die Säulen sind mit bekannten phenolischen Verbindungen kalibriert.

Die Erweichungspunkte sind nach DIN 53 181 (Kapillarmethode) bestimmt. Glasübergangstemperaturen werden kalorimetrisch (DSC) gemessen.

### Beispiel 1:

Für die Kondensationsreaktion und die Aufarbeitung des Reaktionsgemisches wird ein 2 Liter-4-Hals-Glaskolben verwendet, der mit thermostatisierter Heizung, Rührvorrichtung, Thermometer, Zulaufvorrichtung sowie Rückflußkühler mit Wasserabscheider versehen ist. Der Wasserabscheider besitzt ein höhenverstellbaren Siffon, der eine kontinuierliche Abtrennung des Wasser ermöglicht.

### 1. Stufe

In den Reaktor werden 864 Teile p-Kresol, 432 Teile o-Kresol sowie 13 Teile Oxalsäure-Dihydrat gegeben und die Mischung auf 100 °C erhitzt. Wenn diese Temperatur erreicht ist, läßt man 486,5 Teile einer 37 %igen wäßrigen Formaldehyd-Lösung zulaufen und rührt 4,5 Stunden am schwachen Rückfluß, bis der Formaldehyd-Gehalt 0,06 % beträgt. Dann werden am absteigenden Kühler die flüchtigen Bestandteile, zunächst unter Normaldruck, abdestilliert, bis eine Sumpftemperatur von 220 °C erreicht ist. Während dieses Vorganges wird der Kolben mit Stickstoff als Schutzgas gespült. Nach Erreichen von 220 °C wird Vakuum angelegt und der Ansatz eine Stunde bei 30 mbar destilliert. Im Kolben verbleiben 1016 g eines hellgelben Harzes, das einen Erweichungspunkt von 48 °C hat und als 50 %ige Lösung in Methoxypropanol eine Viskosität von 122 mPa·s (23 °C) aufweist. Das Gewichtsmittel der Molekularmasse (M_{w}) beträgt 397, das Zahlenmittel (Mₙ) 310. Der Gehalt an nicht umgesetzten Kresolen liegt unterhalb von 0,1 % der Empfindlichkeitsgrenze des Gelchromatographen.

### 2. Stufe

Zu dem im Reaktor verbliebenen 1016 Teilen Harz werden 508 Teile Xylol sowie eine Lösung von 1 Teil p-Toluolsulfonsäure in 15 Teilen Wasser zugegeben und die Mischung am Umlauf auf 140 °C erhitzt. Bei dieser Temperatur läßt man, gleichzeitig über diesen Zeitraum verteilt, 239 Teile einer wäßrigen, 37 %igen Formaldehyd-Lösung zulaufen. Am Wasserabscheider trennen sich 218 Teile wäßrige Phase ab. Nach Beendigung der Wasserabscheidung gibt man zum Ansatz eine Lösung von 1 Teil Triethanolamin in 15 Teilen n-Butanol und erhitzt den Ansatz am absteigenden Kühler auf eine Sumpftemperatur von 220 °C. Nach Erreichen dieser Temperatur legt man Vakuum an und senkt den Druck auf 100 mbar ab, hält unter diesen Bedingungen den Ansatz noch 15 Minuten und leert ihn dann aus. Es fallen 1020 Teile eines hellen Harzes mit einem Erweichungspunkt von 150 °C und einer Glasübergangstemperatur von 136 °C an. Das Zahlenmittel der Molekularmassenverteilung liegt bei 2907, das Massemittel bei 7635. Die Dispersität der Molekularmassenverteilung (M_{w}/Mₙ) beträgt somit 2,63. Das Gelchromatogramm zeigt ferner, daß innerhalb der Nachweisgrenze von 0,1 % kein nichtumgesetztes Kresol vorhanden ist und daß der Gehalt an Stoffen mit einer Molekularmasse unter 350 < 0,3 % ist.

### Beispiel 2:

1160 Teile des niedrigmolekularen Novolaks aus der 1. Stufe des Beispiels 1, 930 Teile n-Butanol, 230 Teile Xylol werden in den Reaktor gemäß Beispiel 1 gegeben, mit 300 Teilen 33 %igen Natronlauge versetzt und auf 60 °C temperiert. Man gibt unter Rühren innerhalb einer halben Stunde 250 Teile wäßrige, 37 %ige Formaldehyd-Lösung zu und läßt reagieren, bis nach 4 Stunden der Formaldehyd-Gehalt 0,23 % beträgt. Dann stellt man mit 223 Teilen 55 %iger Schwefelsäure einen pH von 4,5 ein und trennt die entstehende wäßrige Phase ab. Der Ansatz wird noch zweimal bei 60 °C mit je 250 Teilen destilliertem Wasser gewaschen und nach Abtrennen der Waschwässer am absteigenden Kühler bis zu einer Sumpftemperatur von 210 °C von den flüchtigen Anteilen befreit. Nach Erreichen von 210 °C legt man Vakuum an und rührt bei 60 mbar/210 °C, bis nach 5 Stunden der Erweichungspunkt mit 163 °C konstant bleibt.

Nach Entleeren des Harzes fallen 1135 Teile eines hellfarbigen Novolakharzes mit einem Erweichungspunkt von 164 °C und einer Glasübergangstemperatur von 142,7 °C an. Das Zahlenmittel der Molekularmassenverteilung liegt bei 2840, das Massenmittel bei 7050. Die Dispersität der Molekularmassen liegt bei 2,48.

### Klebtechnische Prüfung, Bestimmung der Schälfestigkeit (DIN 53 273)

50 Teile des im Beispiel 1 erhaltenen Novolaks und eines Vergleichsnovolaks ®Alnovol PN 630 (Alkylphenol-Formaldehyd-Novolak, Hoechst AG) der bis zu 10 % Zwei- und Dreikernverbindungen enthält, werden jeweils in 50 Teilen Methylethylketon gelöst. Außerdem werden 20 Teile des Polyurethankautschuks ®Desmocoll 540 (Bayer AG) in 80 Teilen Methylethylketon gelöst. Eine Teilmenge der Kautschuklösung bleibt unverändert. Zwei andere Teilmengen werden mit der jeweiligen Novolaklösung so gemischt, daß einmal auf 100 Teile des Polyurethankautschukes 22,5 und im anderen Fall 45 Teile des Harzes (fest auf fest) kommen.

Die offene Zeit wird bestimmt, indem die Klebstofflösungen aus Desmocoll 540 und gegebenenfalls Novolak mit einer Naßfilmstärke von 100 µm auf eine Polyesterfolie aufgezogen werden und von Zeit zu Zeit Streifen abgeschnitten werden und diese auf ihre Klebrigkeit durch Aneinanderpressen von Hand geprüft werden. Nach Abdunsten des Lösemittel besitzt die reine Kautschuklösung überhaupt keine Klebrigkeit. In der Abmischung mit der größeren Menge des erfindungsgemäßen Novolaks geht die Klebrigkeit nach 50 Minuten, mit der kleineren Menge nach 2,5 Stunden verloren. Die offene Zeit von Abmischungen mit der entsprechenden Menge Alnovol PN 630 beträgt 1,1 beziehungsweise 3,2 Stunden.

Die Verklebungen zur Bestimmung der Schälfestigkeit werden 30 Minuten nach Auftragen des Klebefilms durchgeführt. Als Substrat dient Weich-PVC. Mit der Novolak-freien Lösung war keine Verklebung möglich. Die Schälfestigkeiten der beiden anderen Harzlösungen werden nach 7 Tagen Lagerung der Verklebung bei Raumtemperatur durchgeführt. Dabei werden folgende Schälfestigkeiten erhalten:

**Tabelle 1**

| **Schälfestigkeit** | | |
|---|---|---|
| Desmocoll 540/Novolak (fest auf fest) | Schälfestigkeit (N-cm⁻¹) bei | |
| | 23 °C | 50 °C |
| 100 / 22,5 (Novolak aus Beispiel 1) | 62 | 38 |
| 100 / 45 (Novolak aus Beispiel 1) | 53 | 38 |
| 100/22,5 Alnovol PN 630 | 31 | 3 |
| 100/45 Alnovol PN 630 | 28 | 4 |

## Patentansprüche

1. Verfahren zur Herstellung von methylsubstituierten Polyalkylidenpolyphenolen, dadurch gekennzeichnet, daß gegenüber Oxoverbindungen bifunktionelle und/oder trifunktionelle methylsubstituierte Phenole mit Oxoverbindungen in Gegenwart saurer Katalysatoren in erster Stufe zu einem niedermolekularen Polyalkylidenpolyphenol reagiert werden, wobei das Einsatzmolverhältnis zwischen phenolischer Komponente und Oxoverbindungen zwischen 1 : 0,2 bis 1 : 0,7 liegt, die nicht umgesetzten phenolischen Komponenten anschließend destillativ entfernt werden und in zweiter Stufe das nach der Destillation zurückgebliebene niedermolekulare Polyalkylidenpolyphenol in Gegenwart von sauren oder basischen Katalysatoren mit weiteren Oxoverbindungen umgesetzt wird.

2. Verfahren nach Anspruch 1, dadurch gekennzeichnet, daß als Oxoverbindung Formaldehyd eingesetzt wird.

3. Verfahren nach Anspruch 1, dadurch gekennzeichnet, daß als methylsubstituierte Phenole Gemische aus p- und o-Kresol verwendet werden, wobei das Verhältnis zwischen den p- und o-Isomeren 50 : 50 bis 75 : 25 beträgt.

4. Verfahren nach Anspruch 1, dadurch gekennzeichnet, daß die Katalysatoren nach dem jeweiligen Verfahrensschritt neutralisiert werden.

5. Methylsubstituiertes Polyalkylidenpolyphenol, erhältlich nach dem Verfahren gemäß Anspruch 1, mit einer Dispersität der Molekularmassenverteilung (M_{w}/Mₙ) < 4, einer Glasübergangstemperatur oberhalb von 100 °C und einem Erweichungspunkt oberhalb von 120 °C.

6. Polyalkylidenpolyphenol nach Anspruch 5, dadurch gekennzeichnet, daß die Dispersität der Molekularmassenverteilung (M_{w}/Mₙ) < 3,5 beträgt, die Glasübergangstemperatur oberhalb von 110 °C und der Erweichungspunkt oberhalb von 140 °C liegt.

7. Verwendung der Polyalkylidenpolyphenole nach Anspruch 5 in Gegenwart von Hexamethylentetramin und/oder Melaminharzen als Verstärkerharz für Kautschukmischungen.

8. Verwendung der Polyalkylidenpolyphenole nach Anspruch 5 als Klebrigmacher in synthetischen und natürlichen Kautschuken.

9. Verwendung der Polyalkylidenpolyphenole nach Anspruch 5 zusammen mit Kautschuken in Gegenwart von mit 1,3-Dioxoverbindungen komplexierten Alkoholaten oder Phenolaten von Aluminium, Zirkonium oder Titan als Klebstoff.

10. Verwendung der Polyalkylidenpolyphenole nach Anspruch 5 als Bindemittel in lichtempfindlichen Massen.
